# EUROPEAN PATENT APPLICATION

(11) **EP 0 982 791 A2**
(43) Date of publication of application: **01.03.2000**
(21) Application number: 99114686.1
(22) Date of filing: 27.07.1999
(51) Int. Cl.: H01P 1/15, H01P 1/202, H01P 1/213

(54) **Frequency-variable type filter, duplexer and transceiver**

(30) Priority: 11.08.1998 JP 22704598
(71) Applicant: Murata Manufacturing Co., Ltd., Nagaokakyo-shi Kyoto-fu 617-8555 (JP)
(72) Inventor: Atokawa, Masayuki, c/o Intellectual Property Dep., Nagaokakyo-shi, Kyoto-fu 617-8555 (JP)
(74) Representative: Schoppe, Fritz, Dipl.-Ing.

(57) **Abstract**

The invention provides A frequency-variable type filter (1), comprising: a voltage control terminal (CONT 1); at least one resonator (4, 5, 6); and a reactance device capable of being controlled by a control voltage supplied to the voltage control terminal (CONT 1); and the frequency-variable type filter (1) being served as a first filter utilizing a fundamental resonance mode of the resonator (4, 5, 6) when a first control voltage is supplied to the voltage control terminal (CONT 1); whereas the frequency-variable type filter (1) being served as a second filter utilizing a higher resonance mode of the resonator (4, 5, 6) when a second control voltage is supplied to the voltage control terminal (CONT 1).

## Description

### BACKGROUND OF THE INVENTION

### 1. Field of the Invention

The present invention relates to a frequency-variable type filter, a duplexer, and a transceiver, for example, which are used in the microwave band.

### 2. Description of the Related Art]

Recently, a mobile-phone terminal unit having a function compatible with two mobile-phone systems by a single mobile phone has been into actual use. As a typical one, the Dual-Band System of the GSM (Global System for Mobile) and the DCS (Digital Communication System) is known.

As a filter used in this kind of mobile-phone terminal unit, a dielectric filter has been provided in Japanese Unexamined Patent Publication No. 9-8505. In the dielectric filter, a fundamental resonance mode and a higher resonance mode of a λ/4 coaxial resonator are used. For example, a filter has a filter characteristic passing (or attenuating) signals in the 900 MHz band with a fundamental resonance mode and a filter characteristic passing (or attenuating) signals in the 1800 MHz band with a tertiary resonance mode. If the filter has a step structure in which the inner-conductor diameter and the outer-conductor size of a dielectric resonator are different between the open-end side and the short-circuited-end side, the frequency of the tertiary resonance mode is not necessarily required to be set to be a frequency of three times the frequency of the fundamental resonance mode.

However, since the above-mentioned mobile-phone terminal unit has a one-output / one-input system, both the filter characteristic using a fundamental resonance mode and the filter characteristic using a tertiary resonance mode can be simultaneously obtained. Thus, for example, when the filter is used in a mobile-phone terminal unit compatible with the Dual-Band System of the GSM system and the DCS system, even if only the signals of the GSM system in the 900 MHz band are allowed to pass and the signals of the other frequencies are expected to be attenuated, the signals of the DCS system in the 1800 MHz band simultaneously pass, too.

In order to prevent this, it is possible to separately produce a filter compatible with the GSM system and a filter compatible with the DCS system and combine the two filters by electrically connecting. This case, however, creates a new problem in which the size of the filter is increased.

### SUMMARY OF THE INVENTION

To overcome the above described problems, the present invention provides a frequency-variable type filter, a duplexer, and a transceiver, compatible with the Dual-Band System and allowing signals of one system and signals of the other system to pass or to be attenuated independently.

The present invention provides a frequency-variable type filter, a duplexer, and a transceiver, respectively comprising: a voltage control terminal; at least one resonator; and a reactance device capable of being controlled by a control voltage supplied to the voltage control terminal; and the frequency-variable type filter being served as a first filter utilizing a fundamental resonance mode of the resonator when a first control voltage is supplied to the voltage control terminal; whereas the frequency-variable type filter being served as a second filter utilizing a higher resonance mode of the resonator when a second control voltage is supplied to the voltage control terminal.

In the above case, the first filter and the second filter are a band pass filter, a band block filter, or the like. As the reactance device, a PIN diode, a variable capacitance diode, or the like, is used. As for the resonator, a dielectric resonator is used. More specifically, for example, the resonator is electrically connected to a PIN diode through either an inductor or a capacitor, in which a positive voltage is adopted as the first control voltage and 0 V or a negative voltage is adopted as the second control voltage. Or 0 V or a negative voltage is adopted as the first control voltage, and a positive voltage is adopted as the second control voltage.

In the arrangement described above, for example, when the first and second filters are band pass filters, in the case in which the first control voltage is supplied to the voltage control terminal, only the signals of a fundamental resonance mode of the resonator pass through the filter and the signals of a higher resonance mode are attenuated, so that the first filter serves as a band pass filter using a fundamental resonance mode. Meanwhile, when the second control voltage is supplied to the voltage control terminal, only the signals of a higher resonance mode of the resonator pass through the filter and the signals of a fundamental resonance mode are attenuated, so that the second filter serves as a band pass filter using a higher resonance mode. In this way, by changing a control voltage to be supplied to the voltage control terminal, the signals of a fundamental resonance mode and the signals of a higher resonance mode are allowed to independently pass.

Furthermore, a duplexer and a transceiver according to the present invention include one of the frequency-variable filters having the aforementioned features, whereby miniaturization and weight reduction can be achieved.

A description will be given of the embodiments of a frequency-variable type filter, a duplexer, and a transceiver according to the present invention referring to the attached drawings.

### BRIED DESCRIPTION OF DRAWINGS

Fig. 1 is an electric circuit diagram of a first embodiment of a frequency-variable type filter according to the present invention.
Fig. 2 is a sectional view of an example of a resonator used in the frequency-variable type filter shown in Fig. 1.
Fig. 3 is a filter-characteristic illustration chart of the frequency-variable type filter shown in Fig. 1.
Fig. 4 is an electric circuit diagram of a second embodiment of the frequency-variable type filter according to the present invention.
Fig. 5 is a block diagram of an embodiment of a duplexer according to the present invention.
Fig. 6 is a block diagram of an embodiment of a transceiver according to the present invention.
Fig. 7 is a filter-characteristic illustration chart of another embodiment.

### DESCRIPTION OF THE EMBODIMENTS

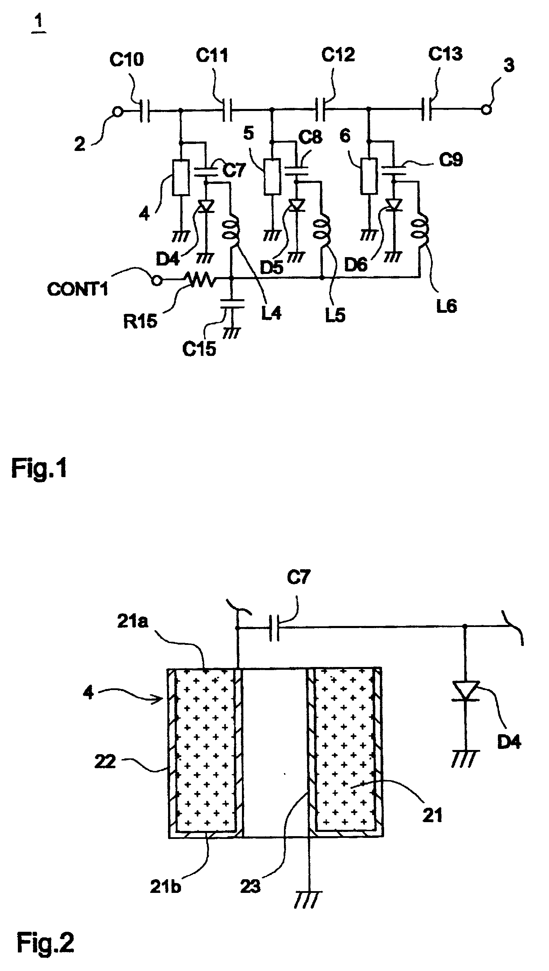

### [First Embodiment, Fig. 1 through Fig. 3]

Fig. 1 shows a circuit structure of a frequency-variable-type band pass filter 1. The frequency-variable-type band pass filter 1 includes three coupled resonance circuits, in which a resonator 4, a resonator 5, and a resonator 5 are electrically connected through coupling capacitors C11 and C12, respectively. The resonator 4 is electrically connected to an outer terminal 2 through a coupling capacitor C10 and the resonator 6 is electrically connected to an outer terminal 3 through a coupling capacitor C13.

One end of the resonator 4 is grounded to a ground, and the other end is electrically connected to a series circuit including a band-varying capacitor C7 and a PIN diode D4 as a reactance device in parallel with respect to the resonator 4, with the cathode of the PIN diode D4 being grounded. One end of the resonator 5 is grounded to a ground, and the other end is electrically connected to a series circuit including a band-varying capacitor C8 and a PIN diode D5 in parallel with respect to the resonator 5, with the cathode of the PIN diode D5 being grounded. One end of the resonator 6 is grounded to a ground, and the other end is electrically connected to a series circuit including a band-varying capacitor C9 and a PIN diode D6 in parallel with respect to the resonator 6, with the cathode of the PIN diode D6 being grounded.

A voltage control terminal CONT1 is electrically connected to the intermediate junction between the anode of the PIN diode D4 and the band-varying capacitor C7 through a control-voltage supplying resistor R15, a capacitor C15, and a chalk coil L4, whereas it is electrically connected to the intermediate junction between the anode of the PIN diode D5 and the band-varying capacitor C8 through the control-voltage supplying resistor R15, the capacitor C15, and a chalk coil L5. Furthermore, the voltage control terminal CONT1 is electrically connected to the intermediate junction between the anode of the PIN diode D6 and the band-varying capacitor C9 through the control-voltage supplying resistor R15, the capacitor C15, and a chalk coil L6.

In addition, as for the resonators 4 through 6, for example, as shown in Fig. 2, λ/4 coaxial dielectric resonators are used. Fig. 2 shows the resonator 4 as a typical one. The dielectric resonators 4 through 6 are formed by a tube-shaped dielectric member 21 made of a high dielectric-constant material such as the TiO₂-based ceramic, an outer conductor 22 disposed on the outer periphery of the tube-shaped dielectric member 21, and an inner conductor 23 disposed on the inner periphery of the tube-shaped dielectric member 21. The outer conductor 22 is electrically open with respect to (separated from) the inner conductor 23 at an opening-end face 21a of the dielectric member 21 (hereinafter referred to as an open-side end face 21a), whereas it is electrically short-circuited (conducted) with respect to the inner conductor 23 at the other opening-end face 21b (hereinafter referred to as a short-circuited-side end face 21b). In the dielectric resonator 4, at the open-side end face 21a of the dielectric resonator 2, the series circuit including the band-varying capacitor C7 and the PIN diode D4 is electrically connected in such a manner that an end of the band-varying capacitor C7 is connected to the inner conductor 23, whereas the cathode of the PIN diode D4 is grounded to a ground, and at the short-circuited-side end face 21b, the outer conductor 22 is grounded to a ground.

A passing frequency of a filter 1 is determined by each resonance frequency of the resonance system composed of the band-varying capacitor C7 and the resonator 4, the resonance system composed of the band-varying capacitor C8 and the resonator 5, and the resonance system composed of the band-varying capacitor C9 and the resonator 6. In other words, the impedance values and inductance values of the resonators 4 through 6 and the capacitance values of the band-varying capacitors C7 through C9 are set to be able to use the filter 1 with a fundamental resonance mode and with a higher resonance mode (a tertiary resonance mode in the case of the first embodiment).

When a positive voltage as a control voltage is applied to the voltage control terminal CONT1, the PIN diodes D4 through D6 are in the ON-state. As a result, the band-varying capacitors C7 through C9 are respectively grounded through the PIN diodes D4 through D6 and the passing frequencies of the fundamental resonance mode and the tertiary resonance mode of the filter 1 are respectively lowered. In contrast, when a negative voltage as a control voltage is applied, the PIN diodes D4 through D6 are in the OFF-state. Instead of applying a negative voltage, a control circuit for supplying a control voltage to the voltage control terminal CONT1 may be set to have high impedance of 100 KO or more so that no voltage is not applied to the voltage control terminal CONT1, whereby the control voltage is 0 V, so that the PIN diodes D4 through D6 can be in the OFF-state. This permits the band-varying capacitors C7 through C9 to be in the open-state and the passing frequencies of the fundamental resonance mode and tertiary resonance mode of the filter 1 are heightened. Therefore, the filter 1 can have two different pass bands by grounding or opening the band-varying capacitors C7 through C9.

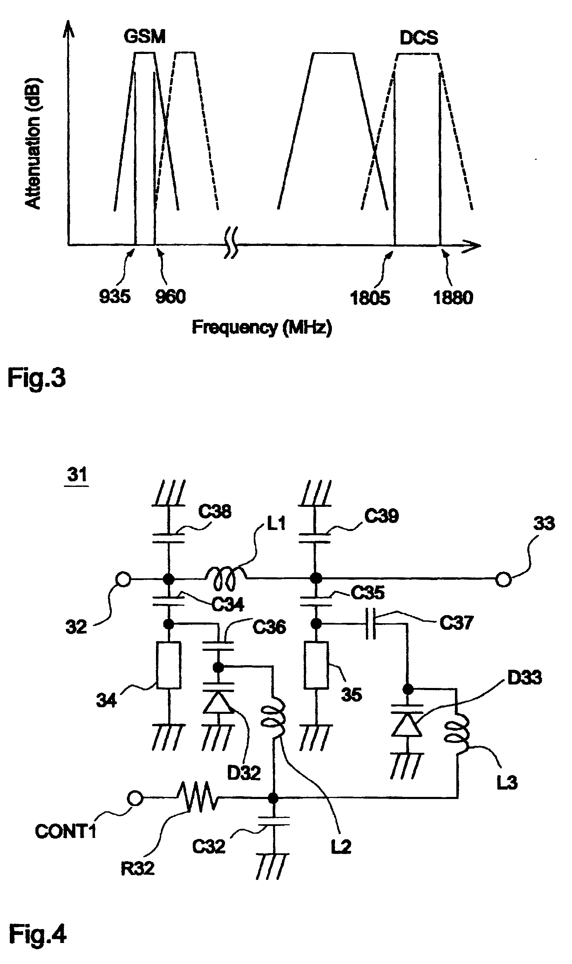

Meanwhile, a reception frequency assigned to the GSM system, as shown in Fig. 3, is in a range of 935 through 960 MHz (the center frequency = 947.5 MHz), and a reception frequency assigned to the DCS system is in a range of 1805 through 1880 MHz (the center frequency = 1842.5 MHz). When a positive voltage is applied to the voltage control terminal CONT1 and the PIN diodes D4 through D6 are in the ON-state so that the passing frequencies of the fundamental resonance mode and the tertiary resonance mode of the filter 1 are lowered, the resonance frequency of the resonance systems including the resonators 4 through 6 of a fundamental resonance mode is set to be equal to the reception frequency of the GSM system (cf. the solid line shown in Fig. 3). In this case, the resonance frequency of the resonance systems including the resonators 4 through 6 of a tertiary resonance mode is set to be slightly lower than the reception frequency of the DCS system. Such a setting is conducted by changing the impedance values and inductance values of the resonators 4 through 6 and the capacitance values of the band-varying capacitors C7 through C9 as required. With this arrangement, the filter 1 can be a band pass filter using a fundamental resonance mode of the resonators 4 through 6 to allow the reception frequency of the GSM system to pass. In contrast, the signals of the tertiary resonance mode (the reception signals of the DCS system) are attenuated.

When a negative voltage is applied to the voltage control terminal CONT1 and the PIN diodes D4 through D6 are in the OFF-state so that the passing frequencies of the fundamental resonance mode and the tertiary resonance mode of the filter 1 are heightened, the resonance frequency of the resonance systems including the resonance systems including the resonators 4 through 6 of a tertiary resonance mode is set to be equal to the reception frequency of the DCS system, whereas the resonance frequency of the resonance systems including the resonators 4 through 6 of a fundamental resonance mode is slightly higher than the reception frequency of the GSM system (cf. the dot-line shown in Fig. 3). Therefore, the filter 1 can be a band pass filter using the tertiary resonance mode of the resonators 4 through 6 to allow the reception frequency of the DCS system to pass. In contrast, the signals of the fundamental resonance mode (the reception signals of the GSM system) are attenuated.

In this way, by switching the GSM system and the DCS system corresponding to the changing of a control voltage to be supplied to the voltage control terminal CONT1, the reception signals of the GSM system and the reception signals of the DCS system can be allowed to independently pass.

### [Second Embodiment, Fig. 4]

Fig. 4 shows a circuit structure of a frequency-variable-type band block filter 31. The frequency-variable-type band block filter 31 is formed by coupling two stages of resonance circuits between outer terminals 32 and 33. In other words, a series resonance circuit composed of a resonator 34 and a resonance capacitor C34 is electrically connected to a series resonance circuit composed of a resonator 35 and a resonance capacitor C35 through a coupling coil L1. The resonance capacitors C34 and C35 are capacitors determining the magnitude of block-band attenuation. In addition, with these two series resonance circuits, capacitors C38 and C39 are electrically connected in parallel.

A variable capacitance diode D32 as a reactance device, whose anode being grounded, is electrically connected to the intermediate junction between the resonator 34 and the resonance capacitor C34 through a band-varying capacitor C36 in parallel with respect to the resonator 34. A variable capacitance diode D33, whose anode being grounded, is electrically connected to the intermediate junction between the resonator 35 and the resonance capacitor C 35 through a band-varying capacitor C37 in parallel with respect to the resonator 35. The band-varying capacitors C37 and C36 are capacitors for changing two attenuation-pole frequencies of attenuation characteristic, respectively.

The voltage control terminal CONT1 is electrically connected to the intermediate junction between the cathode of the variable capacitance diode D32 and the band-varying capacitor C36 through a control voltage supplying resistor R32, a capacitor C32, and a chalk coil L2, and is electrically connected to the intermediate junction between the cathode of the variable capacitance diode D33 and the band-varying capacitor C37 through the control voltage supplying resistor R32, the capacitor C32, and a chalk coil L3.

The trap band of the filter 31 is determined by each resonance frequency of the resonance system composed of the band-varying capacitor C36, the resonance capacitor C34, and the resonator 34 and the resonance system composed of the band-varying capacitor C37, the resonance capacitor C35, and the resonator 35. In other words, the impedance values and inductance values of the resonators 34 and 35, and the capacitance values of the band-varying capacitors C36 and C37 are set in such a manner that the filter 31 can be used both with a fundamental resonance mode and a higher resonance mode (a tertiary resonance mode in the case of the second embodiment).

When a positive voltage as a control voltage is applied to the voltage control terminal CONT1, the variable capacitance diodes D32 and D33 are in the ON-state. As a result, the band-varying capacitors C36 and C37 are respectively grounded through the variable capacitance diodes D32 and D33, whereby the passing frequencies of the fundamental resonance mode and the tertiary resonance mode of the filter 31 are respectively lowered. In contrast, when a negative voltage as a control voltage is applied, the variable capacitance diodes D32 and D33 are in the OFF-state. This permits the band-varying capacitors C36 and C37 to be in the open-state and thereby the passing frequencies of the fundamental resonance mode and the tertiary resonance mode of the filter 31 are heightened.

Therefore, the filter 31 can have two different trap bands by grounding or opening the band-varying capacitors C36 and C37. Accordingly, the filter 31 can independently trap the signals of the two communication systems by switching the two communication systems corresponding to the changing of the control voltage to be supplied to the voltage control terminal CONT1, as in the case of the filter 1 of the first embodiment.

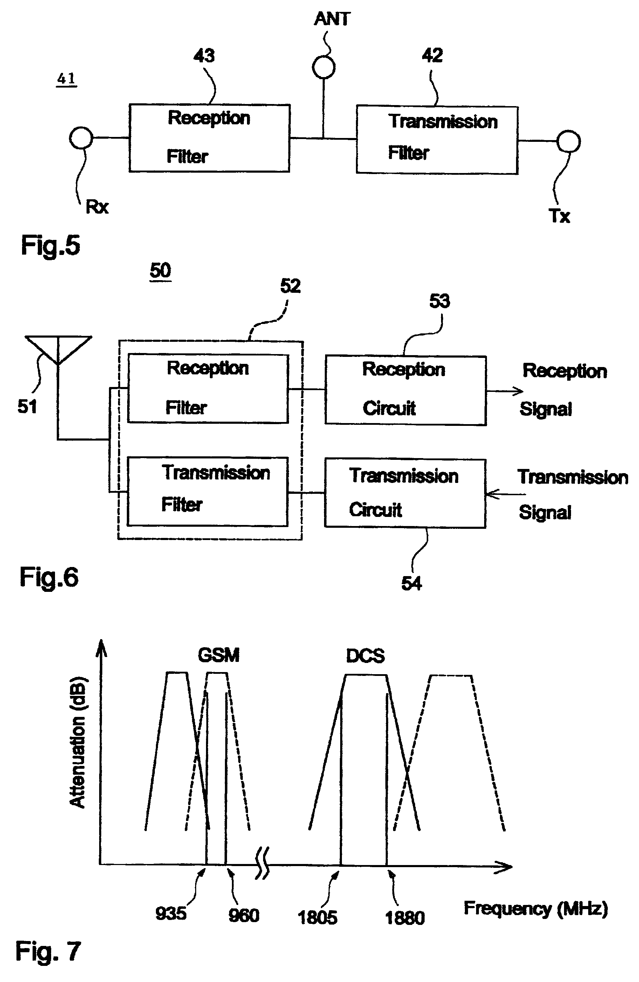

### [Third Embodiment, Fig. 5]

A third embodiment shows a duplexer (an antenna duplexer) according to the present invention. As shown in Fig. 5, in the duplexer 41, a transmission filter 42 is electrically connected between a transmission terminal Tx and an antenna terminal ANT, and a reception filter 43 is electrically connected between a reception terminal Rx and the antenna terminal ANT. In this arrangement, as the transmission filter 42 and the reception filter 43, the frequency-variable type filter 1 or 31 of the first or second embodiment can be used. Mounting of the filter 1 or 31 permits the duplexer 41 to be compatible with the Dual-Band System, so that the duplexer 41, in which the signals of one system and the signals of the other system are allowed to pass independently, can be obtained.

### [Fourth Embodiment, Fig. 6]

A fourth embodiment shows a transceiver according to the present invention, in which a description will be given by taking an example of a mobile phone. Fig. 6 is an electric-circuit block diagram of the RF transmission / reception section of a mobile phone 50. In Fig. 6, 51 is an antenna device, 52 is an antenna duplexer, 53 is a reception circuit, and 54 is a transmission circuit. In this case, as the antenna duplexer 52, the duplexer 41 of the third embodiment can be used. Mounting of the duplexer 41 can enhance communication quality such as noise characteristics of the mobile phone 50.

### [Other Embodiments]

The frequency-variable type filter, the duplexer, and the transceiver according to the present invention should not be limited to those of the embodiments above described, and various modifications can be conducted in the range of the scope and the spirits of the invention. Specifically, in the frequency-variable-type band pass filter 1 of the first embodiment, when a positive voltage is applied to the voltage control terminal CONT1 and the passing frequencies of a fundamental resonance mode and a tertiary resonance mode of the filter 1 are lowered, the resonance frequency of the resonance system including the resonators 4 through 6 of the tertiary resonance mode may be set to be equal to the reception frequency of the DCS system (cf. the solid line shown in Fig. 7). In this case, the resonance frequency of the resonance system including the resonators 4 through 6 of a fundamental resonance mode is set to be slightly lower than the reception frequency of the GSM system. In this arrangement, the filter 1 can be a band pass filter using the tertiary resonance mode of the resonators 4 through 6 to allow the reception frequency of the DCS system to pass. In contrast, the signals of the fundamental resonance mode (the reception signals of the GSM system) are attenuated.

Additionally, when a negative voltage is applied to the voltage control terminal CONT1 and the passing frequencies of a fundamental resonance mode and a tertiary resonance mode of the filter 1 are heightened, the resonance frequency of the resonance system including the resonators 4 through 6 of the fundamental resonance mode and the reception frequency of the GSM system are equal; and the resonance frequency of the resonance system including the resonators 4 through 6 of a tertiary resonance mode is slightly higher than the reception frequency of the DCS system (cf. the dot-line shown in Fig. 7). In this arrangement, the filter 1 can be a band pass filter using the fundamental resonance mode of the resonators 4 through 6 to allow the reception frequency of the GSM system to pass. In contrast, the signals of the tertiary resonance mode (the reception signals of the DCS system) are attenuated.

As described above, according to the present invention, signals of the two communication systems are allowed to pass or to be attenuated by using a fundamental resonance mode and a higher resonance made of a resonator to switch the two communication systems corresponding to the changing of a control voltage to be supplied to a voltage control terminal.

## Claims

1. A frequency-variable type filter (1; 31), comprising:
a voltage control terminal (CONT 1);
at least one resonator (4, 5, 6; 34, 35); and
a reactance device capable of being controlled by a control voltage supplied to the voltage control terminal (CONT 1); and
the frequency-variable type filter (1; 31) being served as a first filter utilizing a fundamental resonance mode of the resonator (4, 5, 6; 34, 35) when a first control voltage is supplied to the voltage control terminal (CONT 1); whereas the frequency-variable type filter (1; 31) being served as a second filter utilizing a higher resonance mode of the resonator (4, 5, 6; 34, 35) when a second control voltage is supplied to the voltage control terminal (CONT 1).

2. The frequency-variable type filter (1) according to Claim 1, wherein the reactance device is a PIN diode (D4, D5, D6).

3. The frequency-variable type filter (31) according to Claim 1, wherein the reactance device is a variable capacitance diode (D32; D33).

4. The frequency-variable type filter (1) according to Claim 2, wherein the resonator (4, 5, 6) is electrically connected to the PIN diode (D4, D5, D6) through either an inductor or a capacitor (C7, C8, C9); the first control voltage is a positive voltage; and the second control voltage is 0 V or a negative voltage.

5. The frequency-variable type filter (1) according to Claim 2, wherein the resonator (4, 5, 6) is electrically connected to the PIN diode (D4, D5, D6) through either an inductor or a capacitor (C7, C8, C9); the first control voltage is 0 V or a negative voltage; and the second control voltage is a positive voltage.

6. The frequency-variable type filter (1; 31) according to one of Claim 1 to Claim 5, wherein the resonator (4, 5, 6; 34, 35) is a dielectric resonator.

7. A duplexer (41) comprising the frequency-variable type filter (1; 31) of one of Claim 1 to Claim 6.

8. A transceiver (50) comprising the frequency-variable type filter (1; 31) of one of Claim 1 to Claim 6, or the duplexer (41) of Claim 7.
